# EUROPÄISCHE PATENTANMELDUNG

(11) **EP 2 298 520 A1**
(43) Veröffentlichungstag der Anmeldung: **23.03.2011**
(21) Anmeldenummer: 10009535.5
(22) Anmeldetag: 14.09.2010
(51) Int. Cl.: B28D 5/00, H01L 21/00

(54) **Vorrichtung und Verfahren zum Reinigen von Wafern**

(30) Priorität: 17.09.2009 DE 102009041644; 31.05.2010 DE 102010022289
(71) Anmelder: Gebrüder Decker GmbH & Co. KG, 92334 Berching (DE)
(72) Erfinder: Götz, Manfred, 92318 Neumarkt (DE)
(74) Vertreter: Stippl, Hubert

(57) **Zusammenfassung**

Die Erfindung betrifft eine Vorrichtung zum Reinigen von Wafern nach dem Drahtsägeprozess umfassend
eine Halteplatte (2, 20), die an ihrer ersten Hauptfläche mit einem Ingot (1) verbunden ist,
einer Montageplatte (3), die mit der zweiten Hauptfläche der Halteplatte (2, 20) verbunden ist,
einer Einrichtung zum Zuleiten von Spülflüssigkeit, um die Wafer im Bereich der Sägespalte zu reinigen, wobei
die Halteplatte (2, 20) eine Vielzahl flächig verteilter, zum Ingot (1) hin orientierter Spülkanäle (4) oder Spüldurchlässe (17) aufweist,
ein dem Ingot (1) abgewandtes Ende vorzugsweise jedes Spülkanals (4) einem Bereitstellungsraum (5) für Spülflüssigkeit gegenüberliegt.

## Beschreibung

### Gegenstand

Die vorliegende Erfindung betrifft eine Vorrichtung sowie ein Verfahren zum Reinigen von Wafern nach dem Drahtsägeprozess gemäß dem Oberbegriff des Anspruchs 1 bzw. Anspruchs 17.

### Technologischer Hintergrund

Wafer, z.B. Silizium-Wafer, werden heutzutage üblicherweise aus einem Block (Ingot) im sogenannten Drahtsägeprozess hergestellt. Das Sägen erfolgt unter Zuhilfenahme eines umlaufenden Drahtes sowie einer abrasive Partikel enthaltenden Sägeflüssigkeit, die sich auf dem Draht befindet. Der Draht "frisst sich" aufgrund der abrasiven Partikel der Sägeflüssigkeit kontinuierlich in den an einer Halteplatte einseitig hängenden Ingot und trennt hierbei den Ingot in einzelne Scheiben, die sogenannten Wafer. Nachdem die Wafer auf diese Art gesägt worden sind, sind sie allerdings nach wie vor mit einer Montageplatte durch Verklebung in tragender Verbindung. Nach Beendigung des Sägevorgangs befindet sich die Sägeflüssigkeit in den Sägespalten an den Schnittflächen der jeweiligen Wafer, was einerseits ein durch Adhäsion begründetes Zusammenhängen der Wafer unter sich bewirkt, sowie andererseits bewirkt, dass die Schnittflächen der einzelnen Wafer durch die Partikel der Sägeflüssigkeit sowie durch Sägespäne (Siliziumsägespäne) verunreinigt sind. Eine Weiterverarbeitung der Wafer setzt allerdings eine Reinigung derselben voraus, so dass jegliche Rückstände an Partikeln der Sägeflüssigkeit sowie an Sägespänen entfernt sind.

### Stand der Technik

Die DE 102 20 468 A1 beschreibt ein Verfahren und eine Vorrichtung zur Reinigung von Wafern, bei denen die Spülflüssigkeit über einen Verteilerkanal zwangsweise zwischen die Wafer in die einzelnen Sägespalten geführt wird. Die Halteplatte, mit der der Ingot verklebt ist, weist hierzu einen einzigen, vorgeformten mittigen und in Längsrichtung verlaufenden Verteilerkanal auf, der über einen korrespondierenden Kanal in der Montageplatte mit Spülflüssigkeit versorgt wird. Wähnend des Sägevorgangs wird die Halteplatte im Bereich der Verklebung mit dem Ingot geringfügig angesägt. Aufgrund der Zuführung von Spülflüssigkeit über den zentralen Kanal sowie der durch das Ansägen der Halteplatte erzeugten weiteren Kanäle gelingt Spülflüssigkeit in den Bereich der Sägespalten und führt zu einem Ausspülen der Sägespalten von Sägerückständen, insbesondere Sägepartikel, Allerdings hat dieses bekannte Verfahren den Nachteil, dass besonders die beiden Außenbereiche des jeweiligen Sägespalts nur unzureichend gereinigt werden. Es stellt sich somit lediglich eine über das Gesamtvolumen der aneinanderliegenden Wafer inhomogene Reinigungswirkung ein. Ferner ist dieses bekannte Verfahren für Siliziumblöcke größerer Länge nicht brauchbar, da bei dem bekannten Verfahren die Reinigungswirkung auch mit der Länge des Kanals abnimmt.

Aus der US 2009/0117713 A1 ist ein Verfahren zur Reduzierung der Adhäsionskräfte im Bereich der Sägespalten einer Waferanordnung beschrieben. In diesem Verfahren wird vorgeschlagen, mittels eines flüssigen oder gasförmigen Mediums kleine Partikel, die als Abstandhalter dienen sollen, in den Bereich der Sägespalten einzubringen und so die Adhäsionskräfte zu überwinden. Dies führt zu einem leichteren Waschen und Vereinzeln der Wafer. Als geeignete Abstandshalter werden Abstandshalter aus Kunststoff oder Glas vorgeschlagen. Allerdings müssen die Abstandshaltepartikel nach der Vereinzelung der Wafer wieder entfernt werden.

### Aufgabe

Die Aufgabe der vorliegenden Erfindung besteht darin, eine gattungsgemäße Vorrichtung sowie ein Verfahren zur Verfügung zu stellen, mit der bzw. dem zum einen eine bessere Reinigung von Waferanordnungen ermöglicht wird.

Des weiteren soll die gattungsgemäße Vorrichtung einen einfachen Aufbau besitzen.

### Beschreibung der Erfindung

Die vorliegende Aufgabe wird durch die Merkmale des Anspruchs 1 gelöst. Die Unteransprüche betreffen zweckmäßige Ausgestaltungen der Erfindung.

Gemäß der Erfindung ist ein zum Ingot hin orientierter, voluminöser sowie flächiger Bereitstellungsraum für Spülflüssigkeit vorgesehen. Dieser Bereitstellungsraum ermöglicht es, Spülflüssigkeit bei Bedarf in unmittelbarer Nachbarschaft zum Ingot großflächig, d.h. im Wesentlichen an die Größenverhältnisse des Ingots angepasst bereitzustellen sowie in die Sägespalte des Ingots einzubringen. Die Begrenzung des Bereitstellungsraums erfolgt durch die mit dem Ingot fest verbundene dünnwandige Halteplatte. Durch Sägeschnitte in der Halteplatte, die vorzugsweise gleichzeitig beim Sägen des Ingots in diese eingebracht werden, kann in einfacher und vorteilhafter Weise eine Spülverbindung zwischen dem quer orientierten Bereitstellungsraum und den einzelnen Sägespalten des Ingots hergestellt werden.

Vorzugsweise sind als Spülverbindung eine Vielzahl von Spüldurchlässe vorgesehen, wobei jeder Spüldurchlass den flächigen Bereitstellungsraum mit dem zugehörigen Sägespalt direkt vertikal verbindet. Hierdurch erfolgt über die gesamte Breite ein unmittelbarer sowie nicht umgelenkter Eintritt der Spülflüssigkeit vom Bereitstellungsraum in den zum jeweiligen Spüldurchlass gehörigen Sägespalt des Ingots.

Der Spüldurchlass sowie Sägespalt im Ingot haben vorzugsweise gleiche Schnittbreite sowie Schnittorientierung, da sie durch ein und denselben Schneidvorgang erzeugt werden.

Die erfindungsgemäße Konzeption des Bereitstellungsraums ermöglicht es, dass dieser eine Fläche aufweist, die den Abmessungen des Ingots angepasst ist, mindestens der Hälfte, vorzugsweise mindestens zwei Drittel der Querschnittsfläche des Ingots entspricht. Auch kann der Bereitstellungsraum entsprechend der Querschnittsform des Ingots (Quadrat, Rechteck etc.) geformt sein, Hierdurch wird eine optimale Reinigungswirkung über die gesamte Fläche des Ingots erzeugt.

Zum erleichterten Einbringen der Spüldurchlässe durch den Sägeschnitt weist die Halteplatte eine Vertiefung bzw. reduzierten Wandstärke in dem Bereich, in dem die Spüldurchlässe eingebracht werden, auf.

Dadurch, dass mindestens ein Vorsprung, vorzugsweise eine Mehrzahl von Vorsprüngen, insbesondere in Form einer Rippe oder eines Stegs von der Platte nach oben in den Bereitstellungsraum hineinragt, bleibt der Sägedraht auch dann geführt, wenn er den Boden der Halteplatte zur Herstellung der Strömungsverbindung nach oben durchgesägt hat. Der Sägedraht kann hierdurch in seiner exakten Position wieder in den Sägespalt des Bodens der Halteplatte eingeführt, d. h. aus diesem nach unten herausgeführt werden ohne am Boden der Halteplatte hängen zu bleiben. Der Sägedraht tritt somit zwar im Bereich des Vorsprungs aus der Ebene des Bodens der Halteplatte nach oben heraus jedoch verbleibt der Sägedraht im Bereich des Vorsprungs in der Ausrichtung des zugehörigen Sägespalts und bleibt damit aber auch entsprechend ausgerichtet. Der Vorsprung wird nicht komplett nach oben hin durchgesägt.

Zweckmäßigerweise ist der Vorsprung quer zur Sägeebene orientiert.

Gemäß einer weitem zweckmäßigen Ausgestaltung der vorliegenden Erfindung weist die Halteplatte eine Vielzahl von in Quer- und/oder Längsrichtung flächig verteilter, zum Ingot hin orientierter, vorzugsweise länglicher Spülkanäle auf, Ferner liegt das dem Ingot abgewandte Ende des jeweiligen Spülkanals einem Bereitstellungsraum für Spülflüssigkeit gegenüber bzw. grenzt an diesen unmittelbar an. Durch die Vielzahl der in der Halteplatte vorgeformten Spülkanäle wird ein homogener Eintritt von Spülflüssigkeit in den jeweiligen Sägespalt gewährleistet und damit eine optimale Spülwirkung erzielt. Gleichzeitig sorgt ein Bereitstellungsraum für Spülflüssigkeit im Bereich der Halteplatte, der dem einzelnen Spülkanal gegenüberliegt, für eine gleichmäßige Druckverteilung an der Verbindungsfläche zu dem Ingot, so dass auch Ingots mit größeren Dimensionen, insbesondere größeren Längen, optimal gereinigt werden können. Die Erfindung ermöglicht es daher, sowohl die Reinigungsintensität als auch die Reinigungsgeschwindigkeit im Vergleich zu herkömmlichen Vorrichtungen erheblich zu verbessern. Die erfindungsgemäße Vorrichtung hat den zusätzlichen Vorteil, dass sie nicht nur eine Vorreinigung, sondern auch eine Endreinigung ermöglicht. Darüber hinaus ist aufgrund der verteilten Spülkanäle und der daraus resultierenden, nach dem Drahtsägeprozess vorhandenen Klebflächenverteilung ein besonders günstiges "Deglueing", d.h. Auftrennen der Klebeschicht zwischen Ingot bzw. Wafer und der Halteplatte möglich.

In vorteilhafter Weise liegt der Bereitstellungsraum für Spülflüssigkeit zumindest einem Teil der Spülkanäle, vorzugsweise allen Spülkanälen, entlang der Halteplatte als gemeinsamer Bereitstellungsraum gegenüber. Dies unterstützt die Möglichkeit eines homogenen Einleitens von Spülflüssigkeit in die einzelnen Sägespalten.

Dadurch, dass gemäß einer zweckmäßigen Ausgestaltung der vorliegenden Erfindung der Bereitstellungsraum durch einen von der Halteplatte und Montageplatte begrenzten Hohlraum gebildet wird, kann in konstruktiv einfacher und daher kostengünstiger Weise der Bereitstellungsraum durch entsprechende Formgebung der Halteplatte sowie Montageplatte geschaffen werden.

Besonders bei Ingots mit großer Länge und infolge dessen entsprechend dimensionierter Halteplatten ist es vorteilhaft, den Bereitstellungsraum durch einzelne Begrenzungswände in einzelne Zonen aufzuteilen, wodurch die Druckverhältnisse über die Länge der Halteplatte betrachtet homogenisiert und daher optimiert werden können. Zudem kann zweckmäßigerweise vorgesehen sein, jeder Zone mit einem eigenen Spülflüssigkeitszulauf, welcher zweckmäßigerweise im Seitenbereich des Bereitstellungsraums beispielsweise an der Montageplatte oder Halteplatte positioniert ist, auszustatten.

Alternativ kann sich der jeweilige Spülmittelzulauf auch an der Oberseite der Vorrichtung, so z.B. an der Oberseite der Montageplatte, befinden, was die Handhabbarkeit bei beengten Platzverhältnissen begünstigt.

Um einen raschen Wechsel zu ermöglichen, kann der jeweilige Spülmittelzulauf mit einer eigenen Schnellkupplung zum Anschluss bzw. Demontage einer Spülflüssigkeitsleitung vorgesehen sein.

Gemäß einer Ausgestaltung der vorliegenden Erfindung ist der Spülkanal als Sackloch ausgebildet, so dass zwischen dem zum Ingot hin orientierten Ende des Sacklochs bis zur unteren Fläche der Halteplatte eine Materialschicht verbleibt, Das Öffnen des Spülkanals hin zum Sägespalt erfolgt dadurch, dass die Unterseite der Montageplatte angesägt wird.

Weiterhin kann der jeweilige Spülkanal am Boden einer in der Halteplatte befindlichen Vertiefung, in der während des Spülens ebenfalls Spülflüssigkeit aus dem Bereitstellungsraum für insbesondere eine Mehrzahl von Spülkanälen sich befindet, angeordnet sein. Insbesondere kann hierdurch ein Art Kanaleffekt der zu den Spülkanälen erfolgenden Strömung erzielt werden. Darüber hinaus gewährleistet diese Ausgestaltung bei einer ausreichenden Steifigkeit eine für die Herstellung der Halteplatte günstige Formgebung.

Die Vertiefung kann hierbei vorzugsweise linienförmig vorgesehen sein, derart, dass beispielsweise mehrere linienförmige Vertiefungen parallel zueinander in Längsrichtung der Halteplatte über deren Breite verteilt angeordnet sind.

Die Form der Spülkanäle kann je nach den Anwendungsanforderungen unterschiedlich sein. Beispielsweise können die Spülkanäle rundliche Form oder auch längliche, z.B. schlitzförmige, Form besitzen,

Benachbarte Spülkanäle können zueinander versetzt angeordnet sein. Die Erfindung erlaubt es aufgrund der vorgeschlagenen Konstruktion, verschiedenste Formen an Spülkanälen zu realisieren.

Die Halteplatte, also die Platte, die mit dem Ingot verklebt ist, ist zweckmäßigerweise als Kunststoffteil, vorzugsweise als Kunstharz- bzw. Gießharzteil vorgesehen. Alternativ kann jedoch auch eine Halteplatte aus Keramik oder Glas oder Glaskeramik verwendet werden, insbesondere dann, wenn es sich um eine Halteplatte mit einfacher Form handelt.

Die vorliegende Erfindung betrifft des Weiteren ein Verfahren zum Reinigen von Wafern nach dem Drahtsägeprozess, welches zur Lösung der eingangs gestellten Aufgabe gekennzeichnet ist durch folgende Verfahrensmerkmale:
a) Einleiten einer Spülflüssigkeit in einen Bereitstellungsraum, welcher sich im Bereich der Halteplatte befindet,
b) Ausbringen der Spülflüssigkeit aus dem Bereitstellungsraum in Richtung im Wesentlichen senkrecht zur Halteplatte in die Sägespalten des Ingots hinein über dem Bereitstellungsraum gegenüberliegende, flächig in Quer- und/oder Längsrichtung der Halteplatte verteilte, vorzugsweise zum Ingot hin gerichtete Spülkanäle oder Spüldurchlässe

Das Ausbringen der Spülflüssigkeit aus dem Bereitstellungsraum in die Sägespalten des Ingots hinein erfolgt unter Druck oder unter der Schwerkraft der Spülflüssigkeit. Die Strömungsverbindung zwischen dem jeweiligen Spülkanal bzw. Spüldurchlass und dem Sägespalt wird durch das Ansägen der Halteplatte oder durch ein Durchsägen der Halteplatte vorzugsweise jeweils während des Sägens des Ingots geschaffen.

### Beschreibung von Ausführungsbeispielen

Zweckmäßige Ausgestaltungen der vorliegenden Erfindung werden nachstehend anhand von Zeichnungsfiguren näher erläutert. Wiederkehrende Merkmale sind der Übersichtlichkeit halber lediglich einmal mit einer Bezugsziffer versehen. Es zeigen:
- Fig. 1: eine erste Ausgestaltung der erfindungsgemäßen Vorrichtung zusam- men mit einem daran befestigen Ingot in perspektivischer Ansicht (Fig. 1A), Ansicht der Unterseite der Halteplatte (Fig. 1B), Schnittdar- stellung entlang der Ebene A-A in Fig. 1B (Fig. 1C) sowie Schnittdar- stellung entlang der Ebene B-B (Fig. 1 D);
- Fig. 2: eine Darstellung der Halteplatte der Ausgestaltung nach Fig. 1 in Oberansicht (Fig. 2A), Detailansicht des Bereichs B in Fig. 2A (Fig. 2B), Schnittdarstellung entlang der Schnittebene A-A in Fig. 2A (Fig. 2C) sowie Detaildarstellung des Bereichs C von Fig. 2C (Fig. 2D);
- Fig. 3: eine Darstellung der Halteplatte der Ausgestaltung nach Fig. 1 in Oberansicht (Fig. 3A), Detailansicht des Bereichs B in Fig. 3A (Fig. 3B), Schnittdarstellung entlang der Schnittebene A-A in Fig. 3A (Fig. 3C) sowie Detaildarstellung des Bereichs C von Fig. 3C (Fig. 3D);
- Fig. 4: eine Darstellung der Halteplatte der Ausgestaltung nach Fig. 1 in Oberansicht (Fig. 4A), Detailansicht des Bereichs B in Fig. 4A (Fig. 4B), Schnittdarstellung entlang der Schnittebene A-A in Fig. 4A (Fig. 4C) sowie Detaildarstellung des Bereichs C von Fig. 4C (Fig. 4D),
- Fig. 5: eine Schnittdarstellung durch die Montageplatte einer weiteren Aus- gestaltung der vorliegenden Erfindung mit einem oberseitigen Spül- flüssigkeitszulauf,
- Fig. 6: eine zweite Ausgestaltung der erfindungsgemäßen Vorrichtung mit einem daran befestigten Ingot in Schnittdarstellung vor der Herstel- lung der Spüldurchlässe ohne Vorsprung (Fig. 6 A) sowie mit Vor- sprung (Fig. 6 B);
- Fig. 7: eine Teilschnittdarstellung der Vorrichtungen nach Fig. 6 nach dem Einbringen der Spüldurchlässe während des Spülvorgangs in Schnitt- darstellung sowie
- Fig. 8: eine Teilschnittdarstellung der Vorrichtungen nach Fig. 6 B während des Sägevorgangs.

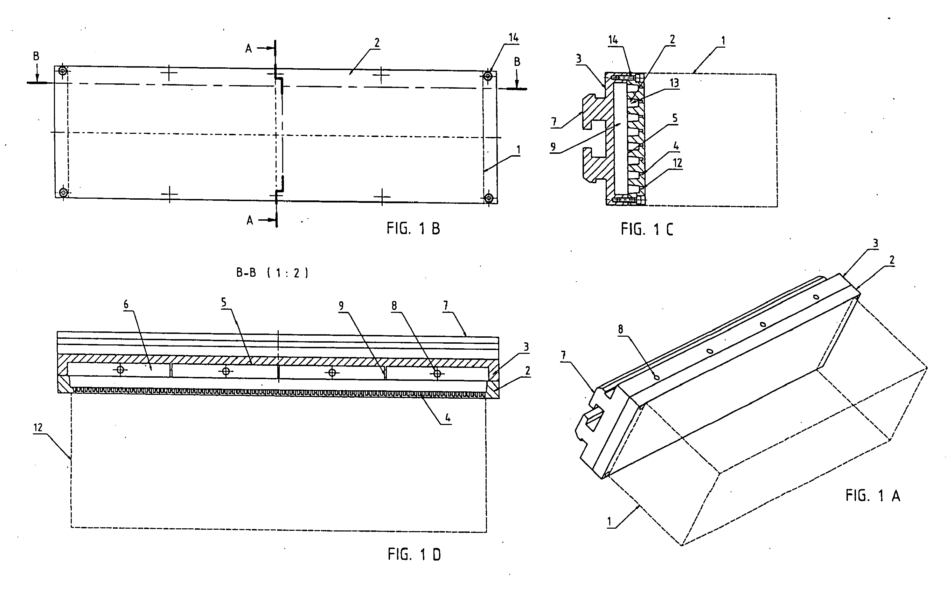

Fig. 1A zeigt eine erste Ausgestaltung der erfindungsgemäßen Vorrichtung in perspektivischer Darstellung, wobei der Ingot, z.B. Siliziumblock, lediglich strichliert angedeutet ist. Der Ingot 1 ist an der Unterseite der Halteplatte 2 (auch "Sägeunterlage" genannt) mittels eines geeignete Klebers vollflächig verklebt. An der Oberseite der Halteplatte 2 befindet sich eine Montageplatte 3 (auch "Ma- schinenträger" genannt) mit Montagevorsprüngen in Form einer Montageschie- ne 7 zur Befestigung der Gesamtanordnung in einer (nicht dargestellten) Drahtsä- ge. Bei dieser Ausgestaltung befinden sich im Bereich der Seitenfläche der Mon- tageplatte 3 mehrere Spülflüssigkeitszuläufe 8, deren Bedeutung später beschrie- ben wird.

Die Halteplatte 2 besteht zweckmäßigerweise aus Porzellan, einem keramischen Werkstoff, aus Glas oder aus einem Harz, insbesondere Gießharz. Sie hat eine Dicke von ca. 2 - 25 mm, vorzugsweise 5 - 15 mm.

Fig. 1B zeigt die Halteplatte 2 aus der Sicht von unten. Zu erkennen sind die Verschraubungen 14 zwischen der Halteplatte 2 und der Montageplatte 3 jeweils im Eckbereich (vgl. auch Fig. 1C).

Halteplatte 2 und Montageplatte 3 bilden zusammen einen Bereitstellungsraum 5 für Spülflüssigkeit. Dieser Bereitstellungsraum 5 erstreckt sich über die gesamte Breite der Halteplatte 2 sowie über deren gesamte Länge. Somit steht Spülflüssigkeit entlang der Halteplatte 2 abzüglich der Wandungen der Montageplatte 3 sowie abzüglich von (später beschriebenen) Begrenzungswänden 9 vollflächig an.

Weiterhin ist die Halteplatte 2, wie in Fig. 1C dargestellt, mit einer Vielzahl vorzugsweise zum Ingot 1 hin gerichteter, einzelner Spülkanäle 4 ausgestattet. Die Spülkanäle 4 dienen dazu, die im Bereitstellungsraum 5 befindliche Spülflüssigkeit unmittelbar in die einzelnen (nicht dargestellten) Sägespalten des Ingots 1 unter Druck einzubringen und so eine homogene Reinigungswirkung sowohl in Längsrichtung als auch in Querrichtung des Ingots 1 zu erzielen.

Wie aus Fig. 1D ersichtlich ist, kann der Bereitstellungsraum 5 mittels einzelner Begrenzungswände 9 in mehrere Zonen 6 unterteilt werden. Die drei Begrenzungswände 9 in Fig. 1D schaffen demzufolge insgesamt vier Zonen 6. Die einzelnen Zonen 6 können mit einer eigenständigen Spülflüssigkeitszuführung ausgestattet sein. Daraus resultiert auch die Möglichkeit, einen kaskadenartigen Spülprozess (Kaskadenspülung) zu realisieren. Hierzu ist im Bereich der Montageplatte 3 ein Spülflüssigkeitszulauf 8 je Zone 6 vorgesehen. Daraus resultiert eine optimierte Druckbeaufschlagung der Spülflüssigkeit über Ingots 1 größerer Länge.

Jeder Spülflüssigkeitszulauf 8 kann über eine eigene (nicht dargestellte) Schnellkupplung verfügen, die es erlaubt, den betreffenden Spülflüssigkeitszulauf 8 mit einer Schlauchverbindung rasch zu koppeln oder zu entkoppeln.

Die Begrenzungswände 9 sind so dimensioniert, dass sie in der Regel bis an die Halteplatte 2 heranreichen.

Wie aus Fig. 1D deutlich wird, wird der Bereitstellungsraum 5 durch das Zusammenwirken der Halteplatte 2 sowie Montageplatte 3 begründet. Die Montageplatte 3 besitzt hierzu eine großflächige Ausnehmung innerhalb der sich die einzelnen Begrenzungswände 9 befinden.

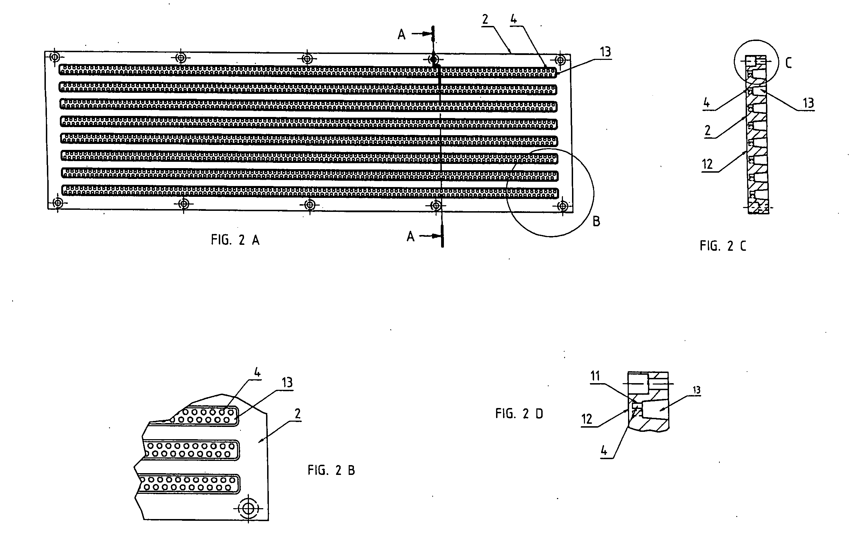

Fig. 2A zeigt die Unterseite der Halteplatte 2. Die einzelnen Spülkanäle 4 sind in rinnenförmigen Vertiefungen 13 jeweils doppelreihig und zueinander versetzt angeordnet. Die rinnenförmige Vertiefungen 13 befinden sich über die Breite der Halteplatte 2 verteilt parallel zueinander verlaufend. Die Seitenwände der rinnenförmigen Vertiefung 13 sind vorzugweise zum Ingot 1 hin verjüngend ausgebildet, was den Eintritt der Spülflüssigkeit aus dem Bereitstellungsraum 5 in die Spülkanäle 4 erleichtert.

Wie aus Fig. 2C bzw. Fig. 2D ersichtlich ist, wird der jeweilige Spülkanal 4 durch ein Sackloch 11 am Boden der Vertiefung 13 gebildet mit der Folge, dass eine Materialschicht 12 zu der der Vertiefung 13 gegenüberliegenden Fläche der Halteplatte 2 verbleibt. Diese Fläche stellt die Montageseite zum Ingot dar, an der sich die Klebeschicht befindet.

Im Drahtsägeprozess wird die Halteplatte 2 im Bereich der Materialschicht 12 angesägt und hierdurch der Spülkanal 4 zum Ingot hin geöffnet.

Gemäß Fig. 2B sind die Sacklöcher 11 von kreisförmigem Umfang und zueinander versetzt. Der Durchmesser eines entsprechenden Spülkanals 4 liegt in einem Bereich von 0,5 mm bis 5,0 mm.

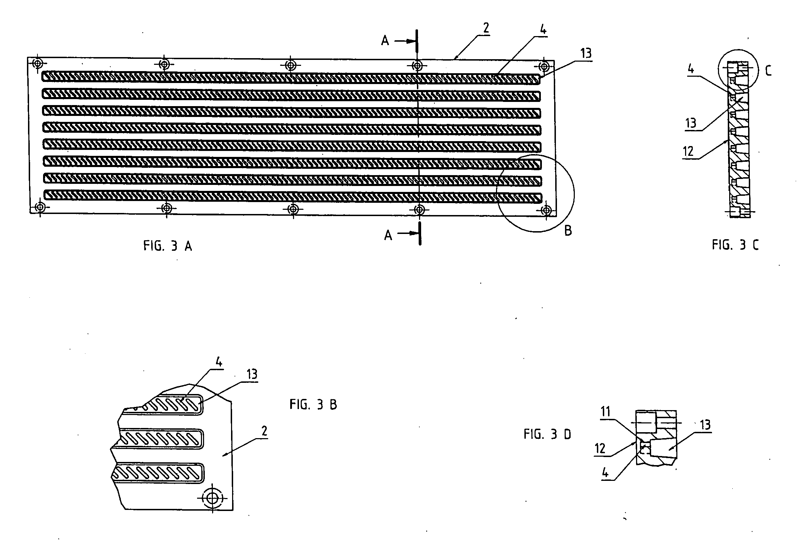

Die Ausgestaltung der vorliegenden Erfindung gemäß den Fig. 3A - 3D unterscheidet sich von der vorgeschriebenen Ausgestaltung in der Form der Spülkanäle 4. Diese sind Sachlöcher von länglicher, schlitzförmiger Gestalt und besitzen eine schräge Orientierung innerhalb der jeweiligen Vertiefung 13.

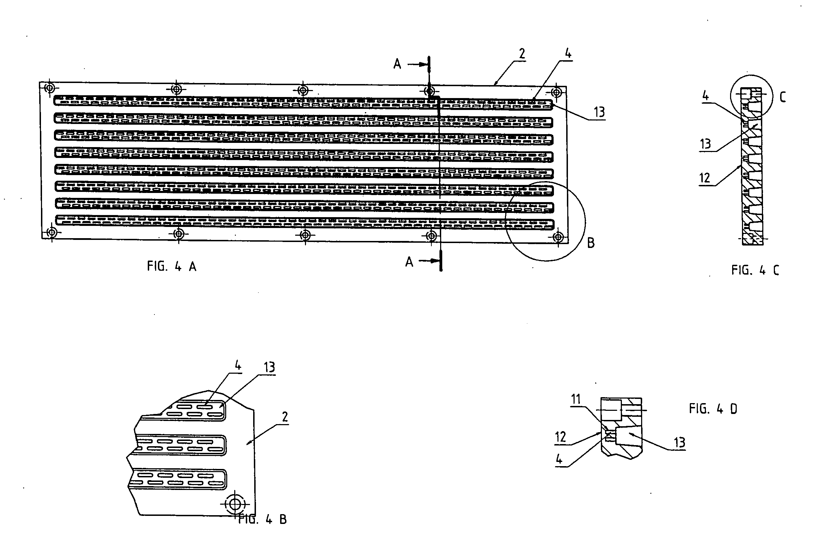

Die Ausgestaltung der vorliegenden Erfindung gemäß den Fig. 4A - 4D unterscheidet sich wiederum in der Form der Spülkanäle 4. Bei dieser Ausgestaltung sind die Spülkanäle 4 ebenfalls von länglicher, schlitzförmiger Form, allerdings in Längsrichtung zu der jeweiligen Vertiefung 13 orientiert und zum benachbarten Spülkanal 4 versetzt.

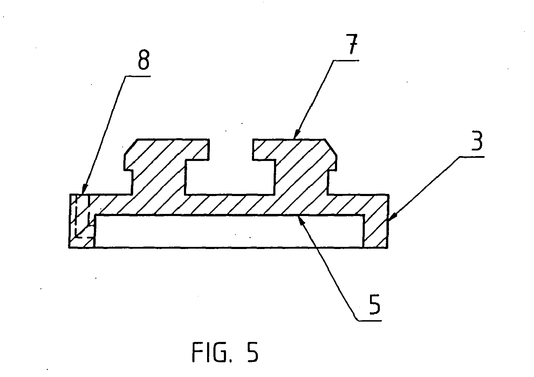

Die Darstellung gemäß Fig. 5 zeigt eine Ausgestaltung der vorliegenden Erfindung, bei der die Spülflüssigkeitszuläufe 8 nicht im Seitenbereich der Vorrichtung, sondern an der Oberseite derselben sich befinden. Hierzu besitzt die Montageplatte 3 einen von ihrer Oberseite her zugänglichen Kanal, der in das Innere des Bereitstellungsraums 5 mündet. Bei mehreren Zonen sind entsprechend den vorbeschriebenen Ausgestaltungen der vorliegenden Erfindung auch mehrere solcher Spülflüssigkeitszuläufe 8 vorgesehen.

Statt die Halteplatte 2 mit der Montageplatte 3 zu verschrauben, können diese auch miteinander verklebt sein.

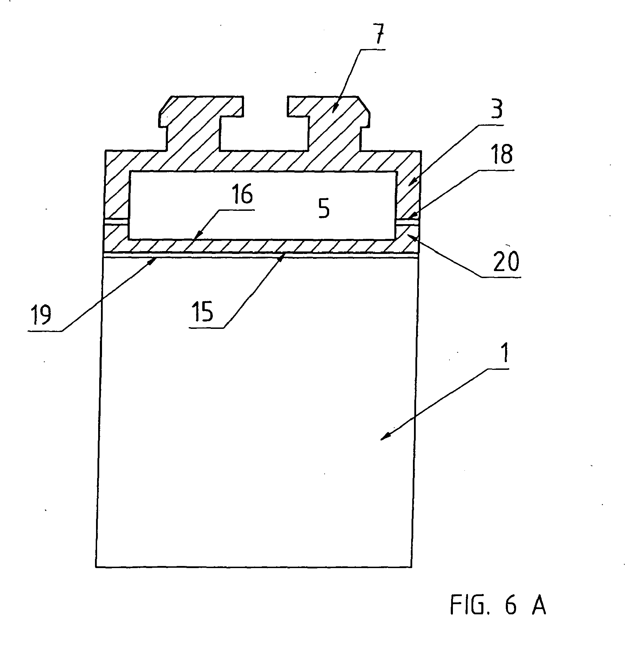

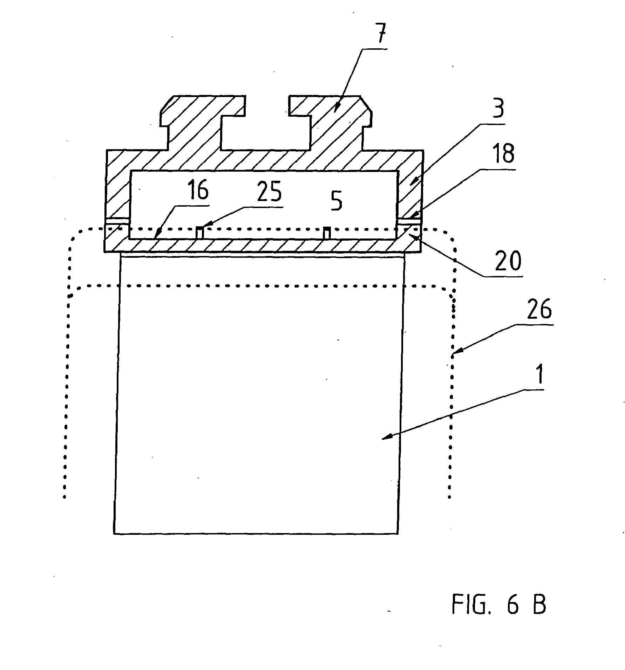

Fig. 6 zeigt eine zweite Ausgestaltung der erfindungsgemäßen Vorrichtung, bei der die Halteplatte 20 keine vorgeformten Spülkanäle der Art, wie sie in den vorangegangenen Ausfübrungsformen mit der Bezugsziffer 4 gekennzeichnet sind, aufweist. Vielmehr ist die Halteplatte 20 entweder als einfache Platte oder, wie in Fig. 6 dargestellt, mit einer innenliegenden Oberseite 16 bzw. mit einer reduzierten Wandstärke ausgestattet. Der Boden 15 der Halteplatte 20 ist bei dieser Ausführungsform mit der Montageplatte 3 über eine Klebeschicht 18 verbunden. Alternativ kann aber auch jede andere mögliche Verbindungsform, wie z.B. eine Verschraubung oder dergl. vorgesehen sein. Der Ingot ist wiederum mit der Unterseite der Halteplatte 20 ebenfalls über eine Klebeschicht 19 verbunden. Bis auf die Ausbildung der Halteplatte 20 gleicht der Aufbau dem der ersten Ausführungsform, so dass darauf Bezug genommen werden kann.

Wie aus Fig. 6 A ersichtlich bilden die Halteplatte 20 sowie Montageplatte 3 einen Bereitstellungsraum 5 für Spülflüssigkeit, welcher sich nahezu über die gesamte Breite sowie Länge des Ingots 1 erstreckt. Jedenfalls ermöglicht es die Konstruktion einen Bereich von mindestens die Hälfte der horizontalen Querschnittsfläche des Ingots 1, vorzugsweise mindestens zwei Drittel der Querschnittsfläche bis zur gesamten Querschnittsfläche des Ingots 1 mit der Flächenerstreckung des Bereitstellungsraums 5 abzudecken.

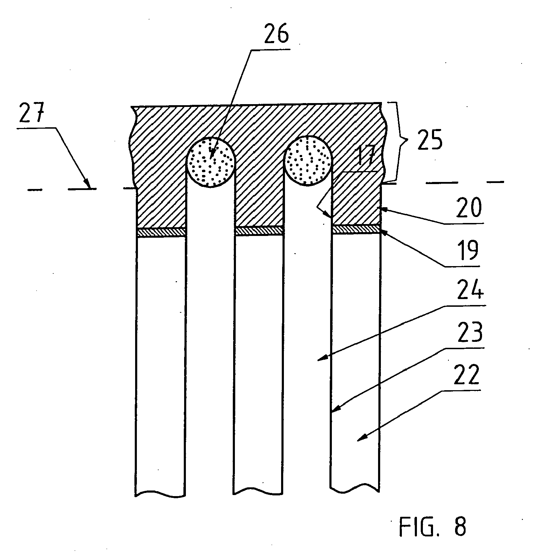

In der Ausgestaltung nach Fig. 6 B ragen zwei Vorsprünge 25 vom Boden der Halteplatte 20 in den Bereitstellungsraum 5 hinein. Die Vorsprünge 25 haben die Form einer Rippe oder eines Stegs und sind quer zur Sägeebene orientiert. Alternativ könnten die Vorsprünge 25 auch beispielsweise schräg zur Sägeebene angeordnet sein. Mit der Bezugsziffer 26 ist der Sägedraht gekennzeichnet, welcher kontinuierlich um läuft und von dem lediglich ein Teilstück abgebildet ist. Die in Fig. 6 B quer verlaufende untere punktierte Linie zeigt den Sägedraht 26 noch unterhalb der Halteplatte 20. Während des Sägevorgangs wandert der Sägedraht 26 innerhalb des Ingots 1 mehr und mehr zur Halteplatte 20 hin, durchschneidet den Boden 15 der Halteplatte 20 schließlich und tritt dann an der Oberseite 16 des Bodens 15 des Bereitstellungsraums (dies entspricht der Ebene 27 des Bereitstellungsraums in Fig. 8) heraus. Hierbei schneidet letzterer einen Sägespalt in den Vorsprung 25 hinein, der gemäß Fig. 8 den in der Halteplatte 20 vorhandenen Sägespalt 23 nach oben hin verlängert und den Sägedraht 26 gleichzeitig in der exakten Ausrichtung hält. Beim anschließenden Entfernen des Sägedrahts 26, bei dem der Sägedraht 26 dann nach unten durch den Sägespalt 23 wieder herausgezogen werden muss, bleibt der Sägedraht 26 hierdurch in der exakten Ausrichtung.

Die Dicke des Bodens der Halteplatte liegt zweckmäßigerweise im Bereich von ca. 2 - 6 mm.

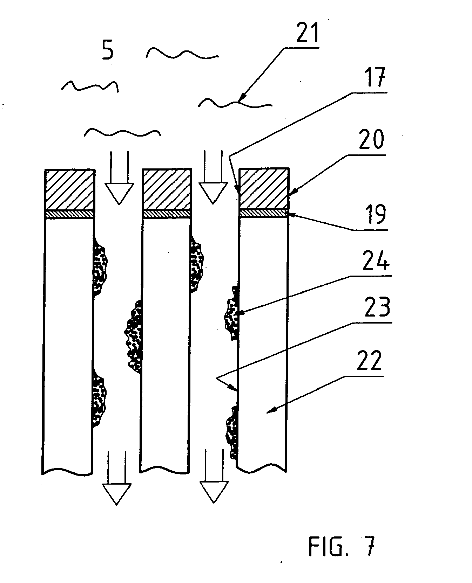

Fig. 7 zeigt zum besseren Verständnis einen vergrößerten Teilbereich des Übergangs von Bereitstellungsraum 5 in den jeweiligen Sägespalt 23. Gemäß der Erfindung wird der Sägevorgang zur Erzeugung des Sägespalts 23 durch den Boden 15 der Halteplatte 20 hindurch durchgeführt, so dass in der Halteplatte 20 und der Klebeschicht 19 pro Sägeschnitt ein Spüldurchlass 17 entsteht, der den Bereitstellungsraum 5 mit dem Sägespalt 23 direkt vertikal verbindet. Demzufolge sind nach erfolgtem Sägevorgang über die gesamte Breite des Ingots 1 und demzufolge auf Grund der flächigen Ausbreitung des Bereitstellungsraums 5 über die gesamte Breite des Bereitstellungsraums 5 eine Vielzahl einzelner, lang gezogener Spüldurchlässe 17 vorhanden.

Die Geometrie (Breite) sowie Orientierung der Spüldurchlässe 17 und Sägespalte 23 sind, da jeweils durch einen einzigen zugehörigen Sägeschnitt erzeugt, identisch.

Nach dem erfolgten Sägen des Ingots 1 wird, wie in Fig. 7 dargestellt, Spülflüssigkeit 21 in den Bereitstellungsraum 5 eingebracht und wird unter Druck oder unter Schwerkraft durch die einzelnen Spüldurchlässe 17 sowie Sägespalte 23 im Ingot 1 hindurch geleitet (siehe Pfeile in Fig. 7), so dass in den Sägespalten 23 befindliche Sägepartikel 24 bzw, Schmutzpartikel über die gesamte Breite des Ingots 1 wirksam entfernt werden können.

Aufgrund der Anordnung des Bereitstellungsraums 5 zwischen Halteplatte 2 und Montageplatte 3 ist es möglich, die Halteplatte 2 als Kumtstoffformteil, insbesondere Gießharzteil zu konzipieren. Bei einem Gießharzteil kann die Formgebung mit den Vertiefungen sowie einzeln angeordneten Spülkanälen 4 bei hinreichender Festigkeit gut realisiert werden. Hinsichtlich der einfachen Form der Halteplatte 20 gemäß der Fig. 6 und 7 besteht der Vorteil, auch eine aus Glas, Keramik oder Glaskeramik bestehende Halteplatte einzusetzen.

Alternativ kann die Halteplatte aber auch aus einem anderen Material bestehen.

Das erfindungsgemäße Verfahren kennzeichnet sich durch folgende Verfahrensmerkmale:
a) Einleiten einer Spülflüssigkeit in einen Bereitstellungsraum, welcher sich im Bereich der Halteplatte befindet,
b) Ausbringen der Spülflüssigkeit in Richtung im Wesentlichen senkrecht zur Halteplatte in die Sägespalten des Ingots hinein über dem Bereitstellungsraum gegenüberliegende, flächig in Quer- und/oder Längsrichtung der Halteplatte verteilte, vorzugsweise gerichtete Spülkanälen bzw. Spüldurchlässe unter Druck.

Besonders vorteilhaft ist es, dass aus einem großvolumigen Bereitstellungsvolnmen an Spülflüssigkeit diese unmittelbar durch die Spülkanäle 4 hindurch in flächiger Verteilung in die einzelnen Sägespalten der gesägten Ingots eingebracht werden kann und hierdurch sowohl die Reinigungseffektivität als auch Reinigungsgeschwindigkeit erheblich gesteigert werden können.

Die Strömungsverbindung zwischen dem jeweiligen Spülkanal 4 und dem Waferspalt wird durch Ansägen der Halteplatte 2 bzw. Durchsägen des Bodens 15 der Halteplatte 20 bewirkt.

Alles in allem stellt die vorliegende Erfindung einen ganz besonderen Beitrag auf dem einschlägigen Gebiet der Technik dar und ermöglicht es gleichzeitig, die Produktionsgeschwindigkeit im Bereich des Vor- und Endreinigens von gesägten Silizium-Ingots erheblich zu steigern,

### BEZUGSZEICHENLISTE

- 1: Ingot
- 2: Halteplatte
- 3: Montageplatte
- 4: Spülkanal
- 5: Bereitstellungsraum
- 6: Zone
- 7: Montageschiene
- 8: Spülflüssigkeitszulauf
- 9: Begrenzungswand
- 10: Schnellkupplung
- 11: Sackloch
- 12: Materialschicht
- 13: Vertiefung
- 14: Verschraubung
- 15: Boden
- 16: Oberseite von Boden der Halteplatte
- 17: Spüldurchlass
- 18: Klebeschicht
- 19: Klebeschicht
- 20: Halteplatte
- 21: Spülflüssigkeit
- 22: Wafer
- 23: Sägespalt
- 24: Sägepartikel
- 25: Steg
- 26: Sägedraht
- 27: Ebene Boden Bereitstellungsraum

## Patentansprüche

1. Vorrichtung zum Reinigen von Wafern (22) nach dem Drahtsägeprozess umfassend
eine Halteplatte (2, 20), die an ihrer ersten Hauptfläche mit einem Ingot (1) verbunden ist,
einer Montageplatte (3), die mit der zweiten Hauptfläche der Halteplatte (2,20) verbunden ist,
eine Einrichtung zum Zuleiten von Spülflüssigkeit (21) , um die Wafer (22) im Bereich der Sägespalte (23) zu reinigen,
**dadurch gekennzeichnet, dass**
ein flächiger Bereitstellungsraum (5) für Spülflüssigkeit (21) vorgehen ist,
die Halteplatte (2, 20) den Bereitstellungsraum (5) zum Ingot (1) hin begrenzt und
Sägeschnitte in der Halteplatte (2,20) eine Spülverbindung zwischen dem Bereitstellungsraum (5) und den einzelnen Sägespalten (23) des Ingots (1) begründen.

2. Vorrichtung nach Anspruch 1,
**dadurch gekennzeichnet, dass**
als Spülverbindung eine Vielzahl von Spüldurchlässen (17) vorgesehen sind und jeder Spüldurchlass (17) den Bereitstellungsraum (5) und den zugehörigen Sägespalt (23) direkt verbindet.

3. Vorrichtung nach Anspruch 1 oder 2,
**dadurch gekennzeichnet, dass**
der Spüldurchlass (17) und der jeweilige Sägespalt (23) im Ingot (1) gleiche Schnittbreite und Schnittorientierung haben.

4. Vorrichtung nach mindesten einem der vorhergehenden Ansprüche,
**dadurch gekennzeichnet, dass**
der Bereitstellungsraum (5) eine Fläche aufweist, die einen Bereich von mindestens der Hälfte, vorzugsweise mindestens zwei Drittel der Querschnittsfläche bis zur gesamten Querschnittsfläche des Ingots (1) entspricht.

5. Vorrichtung nach mindesten einem der vorhergehenden Ansprüche,
**dadurch gekennzeichnet, dass**
die Halteplatte (20) eine Vertiefung aufweist, die den unteren Bereich des Bereitstellungsraum (5) festlegt.

6. Vorrichtung nach mindesten einem der vorhergehenden Ansprüche,
**dadurch gekennzeichnet, dass**
mindestens ein Vorsprung (25) von der Halteplatte (20) in den Bereitstellungsraum hineinragt.

7. Vorrichtung nach mindesten einem der vorhergehenden Ansprüche,
**dadurch gekennzeichnet, dass**
die Halteplatte (2) eine Vielzahl flächig verteilter, zum Ingot (1) hin orientierter Spülkanäle (4) aufweist sowie
ein dem Ingot (1) abgewandtes Ende eines Spülkanals (4) dem Bereitstellungsraum (5) für Spülflüssigkeit gegenüberliegt.

8. Vorrichtung nach Anspruch 7,
**dadurch gekennzeichnet, dass**
der Bereitstellungsraum (5) zumindest einem Teil der Spülkanäle (4), vorzugsweise aller Spülkanäle (4) gegenüberliegt.

9. Vorrichtung nach mindestens einem der vorhergehenden Ansprüche,
**dadurch gekennzeichnet, dass**
der Bereitstellungsraum (5) durch einen von der Halteplatte (2, 20) und der Montageplatte (3) begrenzten Hohlraum gebildet ist.

10. Vorrichtung nach mindestens einem der vorhergehenden Ansprüche,
**dadurch gekennzeichnet, dass**
mindestens eine, den Bereitstellungsraum (5) durchsetzende Begrenzungswand (9) vorgesehen ist, die den Bereitstellungsraum (5) in einzelne Zonen (6) aufteilt.

11. Vorrichtung nach Anspruch 10,
**dadurch gekennzeichnet, dass**
jede Zone (6) einen zugehörigen Spülflüssigkeitszulauf(8) aufweist.

12. Vorrichtung nach Anspruch 11,
**dadurch gekennzeichnet, dass**
der jeweilige Spülflüssigkeitszulauf (8) sich entweder im Bereich der Oberseite der Vorrichtung oder im Bereich der Längsseite der Vorrichtung befindet.

13. Vorrichtung nach Anspruch 11 oder 12,
**dadurch gekennzeichnet, dass**
der Spülflüssigkeitszulauf (8) mit einer Schnellkupplung (10) zum Koppeln bzw. Entkoppeln einer Spülflüssigkeitsleitung vorgesehen ist.

14. Vorrichtung nach mindestens einem der Ansprüche 7 - 13,
**dadurch gekennzeichnet, dass**
der Spülkanal (4) als Sackloch (11) ausgebildet ist.

15. Vorrichtung nach Anspruch 14,
**dadurch gekennzeichnet, dass**
der jeweilige Spülkanal (4) am Boden einer in der Halteplatte (2) befindlichen Vertiefung angeordnet ist.

16. Vorrichtung nach Anspruch 15,
**dadurch gekennzeichnet, dass**
die Vertiefung (13) linienförmig ist und mehrere Vertiefungen in (13) parallel zueinander in Längsrichtung der Halteplatte (2) über deren Breite verteilt angeordnet sind.

17. Vorrichtung nach mindestens einem der vorhergehenden Ansprüche,
**dadurch gekennzeichnet, dass**
die Halteplatte (2, 20) ein Kunststoffteil, insbesondere ein aus Harz hergestelltes Teil ist oder die Halteplatte (2, 20) aus Glas, Keramik oder Glaskeramik besteht.

18. Verfahren zum Reinigen von Wafern nach dem Drahtsägeprozess, wobei Spülflüssigkeit über die Halteplatte dem jeweiligen Sägespalt des Ingots zugeführt wird,
**gekennzeichnet durch**
folgende Verfahrensmerkmale:
a) Einleiten der Spülflüssigkeit (21) in einen Bereitstellungsraum(5), welcher sich im Bereich der Halteplatte (2, 20) befindet,
b) Ausbringen der Spülflüssigkeit (21) in Richtung im Wesentlichen senkrecht zur Halteplatte (2, 20) in die Sägespalten (23) des Ingots (1) hinein über dem Bereitstellungsraum (5) gegenüberliegende, flächig in Quer- und/oder Längsrichtung der Halteplatte (2, 20) verteilte, vorzugsweise zum Ingot (1) hin gerichtete, längliche Spülkanäle (4) oder Spüldurchlässe (17).

19. Verfahren nach Anspruch 18,
**dadurch gekennzeichnet, dass**
die Strömungsverbindung zwischen Spülkanal (4) und Sägespalt (23) durch Ansägen der Halteplatte (2) erfolgt.

20. Verfahren nach Anspruch 18,
**dadurch gekennzeichnet, dass**
die Spüldurchlässe (17) durch ein Durchsägen des Bodens (15) der Halteplatte (20) beim Sägen des Ingots (1) erzeugt werden.
